Europäisches Patentamt

European Patent Office

Office européen des brevets

(19)

(11) **EP 0 584 448 B1**

(12) **EUROPÄISCHE PATENTSCHRIFT**

(45) Veröffentlichungstag und Bekanntmachung des Hinweises auf die Patenterteilung:
**11.06.1997 Patentblatt 1997/24**

(51) Int Cl.$^6$: **G01R 15/24**

(21) Anmeldenummer: **93103818.6**

(22) Anmeldetag: **10.03.1993**

(54) **Strommessanordnung für eine Kabelstrecke**

Current measuring appliance for a length of cable

Dispositif de mesure de courant pour câble

(84) Benannte Vertragsstaaten:
**AT BE FR GB IT NL**

(30) Priorität: **22.08.1992 DE 4227903**

(43) Veröffentlichungstag der Anmeldung:
**02.03.1994 Patentblatt 1994/09**

(73) Patentinhaber: **Felten & Guilleaume Energietechnik AG**
**D-51058 Köln (DE)**

(72) Erfinder:
• **Harjes, Bernd, Dr. Ing.**
**W-5060 Bergisch Gladbach 2 (DE)**
• **Senftleben, Hartwig, Dipl.-Ing.**
**W-4600 Dortmund 1 (DE)**
• **Peier, Dirk, Prof. Dr. Ing.**
**W-4600 Dortmund 50 (DE)**

(56) Entgegenhaltungen:
EP-A- 0 108 012          EP-A- 0 452 218
DE-A- 2 835 794          DE-A- 2 924 804
DE-A- 3 615 557

• **IEEC J LIGHTWAVE TECHN Bd. 7, Nr. 12 , Dezember 1989 Seiten 2084 - 2094 LAMING UND PAYNE 'electric current sensors employing spun highly birefringent optical fibers'**

# Beschreibung

Die Erfindung betrifft eine Strommeßanordnung für eine Strecke einer Energieader eines Energiekabels mit teilweise im Energiekabel integrierten, polarisationserhaltenden Lichtwellenleitern, die als Faraday-Spulen ausgebildet und hintereinander geschaltet sind und mit an einem Ende der Strecke vorhandenen Einrichtungen zum Ein- und Auskoppeln von Licht und mit einer Einrichtung zum Auswerten optischer Signale.

Es wurde bei einer Strommeßanordnung dieser Art schon vorgeschlagen, zwei in gleich langen Kabelstrecken integrierte Lichtwellenleiter jeweils mit gleichem Schlag in Reihe hintereinander zu schalten und diese Anordnung als Einrichtung zur Detektion eines Fehlerstroms über die Änderung des Drehwinkels der Polarisationsebene (Faraday-Effekt) zu verwenden (EP 010 8012, DE 3615557). Mit solchen Anordnungen ist es jedoch nicht möglich, die Fehlerstromstärke quantitativ oder sogar die örtliche Lage des Fehlers in einer Kabelstrecke festzustellen. Diese Anordnungen haben nur die Eigenschaft eines Fehlermelders, solange der Fehler nicht am Anfang oder am Ende der Strecke auftritt.

Der Erfindung liegt die Aufgabe zugrunde, eine Strommeßanordnung der eingangs genannten Art für eine Strecke einer Energieader eines Energiekabels anzugeben, welche es gestattet, genauere Daten über den Fehlerstrom und insbesondere auch über den Fehlerstromort zu ermitteln.

Die Aufgabe wird erfindungsgemäß mit den Merkmalen des Hauptanspruchs gelöst. Vorteilhafte Weiterbildungen finden sich in den Unteransprüchen.

Mit der Erfindung wird eine Kombination von konzentrierten und verteilten, faseroptischen Stromsensoren in Energiekabeln oder -leitungen realisiert. Als konzentrierte Stromsensoren werden enggewickelte Lichtwellenleiterspulen und als verteilte Stromsensoren Lichtwellenleiterspulen mit langem Schlag verstanden, mit denen jeweils die Stromstärke in einem elektrischen Leiter aufgrund des Faraday-Effekts meßbar ist. Die so beschriebenen Lichtwellenleiterspulen werden im folgenden als Faraday-Spulen bezeichnet. Das Magnetfeld der Energieader erzeugt aufgrund des Faraday-Effekts eine Drehung der Polarisationsebene des in den Lichtwellenleiter eingestrahlten Lichts (in der Regel im infraroten Wellenlängenbereich). In konzentrierten Stromsensoren wird die Messung des Faraday-Effekts auf eine im Vergleich zur Länge der Energieleitung (km) vernachlässigbar kurzen Strecke (cm) begrenzt. Verteilte Stromsensoren erfassen die Faraday-Drehung demgegenüber auf einer ausgedehnten Strecke, bis hin zur gesamten Leitungslänge.

Beim Hintereinanderschalten mehrerer Faraday-Spulen addieren sich die Werte der Drehung der Polarisationsebene in jeder Spule. Die Winkeldrehungen subtrahieren sich, wenn die Faraday-Spulen mit entgegengesetzter Wickelrichtung hintereinander liegen. Im folgenden sollen die zu einem Stromsensor gehörenden, hintereinander geschalteten Spulen als Faraday-Teilspulen bezeichnet werden. Es ist bekannt, daß sich reziproke Störeffekte, z.B. der Temperatureinfluß bei torsionsinduzierter Doppelbrechung, bei Hin- und Zurückführen auf demselben optischen Weg auslöschen, während der nichtreziproke Faraday-Effekt in seiner Wirkung verdoppelt wird. Die Verdopplung des Lichtweges wird erreicht, indem das Licht am Ende der Faraday-Spule mit einem Spiegel reflektiert wird.

Die Lichtwellenleiter der verteilten Stromsensoren werden an einem Ende aus der den Leiter aufnehmenden Energieleitung (z.B. Kabel) herausgeführt und mit Einrichtungen versehen, um die optischen Signale ein- und auszukoppeln. Die ausgekoppelten Signale werden einer Auswerteeinrichtung (z. B. in einer Leitwarte) zugeführt. Es ist bekannt, Lichtwellenleiter nicht nur in Kabeln sondern auch in Muffen oder Endverschlüssen zu integrieren, so daß schon bei der Herstellung der Kabel, der Muffen oder Endverschlüsse die Voraussetzung auch für eine integrierte Strommeßanordnung geschaffen wird.

Störeinflüsse können in Lichtwellenleitern lineare Doppelbrechung erzeugen, die eine Fortleitung des Faraday-Signals unmöglich macht. Es werden daher für die Ausbildung der faseroptischen Stromsensoren solche Lichtwellenleiter eingesetzt, bei denen der Polarisationszustand der geführten Lichtwelle nicht durch Störeinflüsse beeinflußt ist. Beispiele solcher Lichtwellenleiter sind Speziallichtwellenleiter (spun high birefrengence: im Aufsatz von R.I. Laming und D.N.Payne in IEEC J Lightwave Techn 7:1989:2084) oder durch Torsion gewöhnlicher Monomode-Fasern präparierte Lichtwellenleiter (DE 2835794).

Im folgenden sollen die Lichtwellenleiter, die das Faraday-Nutzsignal nicht verfälschen, als polarisationserhaltende Lichtwellenleiter bezeichnet werden.

Es wird vorgesehen, daß mindestens ein Lichtwellenleiter als mechanisch verdrillter Monomode-Lichtwellenleiter ausgebildet ist (DE 2835794). Die Lichtwellenleiter werden für die Realisierung der verteilten Stromsensoren im Kabel auf einer längeren Strecke, vorzugsweise im Kabelschirmbereich, integriert.

In einer besonderen Ausgestaltung wird vorgeschlagen, den Lichtwellenleiter in Form einer Schraubenfeder um eine Stützfaser zu winden und gegen Zurückdrehen zu fixieren. Einzelheiten dieser Technik sind beschrieben in der Dissertation von Holger Hirsch, Univers. Dortmund, 1991. Dieser Typ Lichtwellenleiter ist einfach herstellbar und daher kostengünstiger als Lichtwellenleiter, denen die Eigenschaft der Polarisationserhaltung im Ziehprozeß aufgeprägt werden muß.

Die Stützfaser kann selbst ein Lichtwellenleiter sein, so daß sie als informationsführender Lichtwellenleiter der Strommeßanordnung einsetzbar ist. Dies bringt einen weiteren Vorteil mit sich, weil die Stützfaser funktional im Meßsystem nutzbar ist. Während des Umeinanderwindes verdrillen sich beide Lichtwellenleiter mit dem gleichen Schlag umeinander (Doppelschraube). Die gegenseitige Fixierung, die das mechanische Zurückdrehen verhindert, ist hierbei leicht möglich. Der als Stützfaser eingesetzte informationsführende Lichtwellenleiter kann auch als Sensorlichtwellenleiter, z.B. für Zwecke der Übermittlung von Betriebszuständen des Kabels (Temperaturen oder Drücke) oder als Rückführleitung der Signale der Strommeßanordnung eingesetzt werden. Insofern entsteht eine symmetrische Ausgestaltung beider doppelt-gewundenen Lichtwellenleiter mit jeweils austauschbarer Beanspruchung des einen oder des anderen. Der zweite Lichtwellenleiter der Doppelschraube kann aber auch in Reserve liegen bleiben und nur bei Bedarf aktiviert werden. Unabhängig von seiner Betriebsweise (als Sensor für Betriebszustände des Kabels oder als Stromsensor) kann jeder Lichtwellenleiter der Strommeßanordnung als Kommunikationslichtwellenleiter verwendet werden.

Der wesentliche Vorzug der Erfindung ist die Möglichkeit der simultanen Bestimmung von Fehlerstromstärke und Fehlerstromort.

Der erste Stromsensor besteht aus zwei hintereinander geschalteten, eng gewickelten Lichtwellenleiterspulen mit nahezu gleicher Windungszahl und entgegengesetzter Wicklungsrichtung an jedem Ende der Kabelstrecke. Die durch Lichtwellenleiter gebildete Verbindung beider konzentrierten Lichtwellenleiterspulen wird so in der Kabelstrecke integriert, daß das Magnetfeld des Kabels keinen Einfluß auf die Lichtwellenleiterverbindung ausüben kann. Mit dem ersten Stromsensor ist die Differenz der Ströme meßbar, die die Teilspulen durchfließen. Bei Fehlerfreiheit in der Kabelstrecke ist die Stromdifferenz und die Meßgröße Null. Liegt ein Fehler an beliebiger Stelle der Kabelstrecke vor (Erdschluß, Phasenschluß), bei dem die Strombilanz an den Enden der Kabelstrecke ungleich Null ist, entsteht eine endliche Winkeldrehung der Polarisationsebene. Gleiche Windungszahl ist Voraussetzung für eine genaue Messung. Bei unterschiedlichen Windungszahlen entsteht ein Fehlereinfluß, der über mathematische Beziehungen nicht korrigierbar ist.

Der zweite Stromsensor ist ebenfalls ein Differenzstromsensor und besteht aus einem an einem Ende der Kabelstrecke konzentrierten und einem über der Kabelstrecke verteilten faseroptischen Stromsensor, die hintereinander geschaltet sind. Die Wicklung der einen Faraday-Teilspule ist der Wickelrichtung der zweiten Faraday-Teilspule entgegengesetzt, die Anzahl der Windungen der Teilspulen sind nahezu eineinander gleich.

Die Lage der konzentrierten Faraday-Teilspule des zweiten Stromsensors ist frei wählbar am Anfang oder am Ende der Kabelstrecke. Die Lage ist ohne Einfluß auf die Sensorfunktion.

Für sich betrachtet, stellt der zweite Stromsensor einen Fehlerstrommelder dar, der eine qualitative Aussage über das Vorliegen eines Fehlers zuläßt. Die Genauigkeit dieser Messung hängt dabei vom Fehlerstromort und von der Fehlerstromstärke ab.

Beide Stromsensoren werden gemeinsam in einem Kabelabschnitt installiert.

Im fehlerfreien Fall wird die vom Strom in der ersten Faraday-Teilspule (Windungszahl N1') des ersten Stromsensors induzierte Drehung der Polarisationsebene durch die Drehung in der zweiten Faraday-Teilspule (Windungszahl N1") kompensiert. Im Formelzusammenhang:

$$\phi 1 = 2\ V\ I1\ N1' - 2\ V\ I2\ N1''$$

wegen: $N1' = N1'' = N1$

$$\phi 1 = 2\ V\ N1\ (I1 - I2).$$

I1, I2 sind die Ströme (als Vektorgrößen) am Ort der Faraday-Teilspulen; V ist die Verdet-Konstante. Im Fehlerfall ist die verbleibende Faraday-Drehung $\phi 1$ ein direktes Maß für die Fehlerstromstärke $I_F = I1 - I2$. .

Für den zweiten Stromsensor ergibt sich die Faraday-Drehung $\phi 2$:

$$\phi 2 = 2\ V\ I1\ N2'\ z/L + 2\ V\ I2\ N2'(1-z/L) - 2\ V\ I2\ N2''.$$

Hierbei ist N2' die Windungszahl der verteilten und N2" die Windungszahl der konzentrierten Faraday-Spule des zweiten Stromsensors. Die Windungszahl N2' ist gleich dem Verhältnis Länge der Kabelstrecke L zu Schlaglänge s. z ist die Koordinate des Fehlerstromorts. Da die Windungszahlen der Faraday- Teilspulen des zweiten Stromsensors untereinander gleich sind, d.h. $N2 = N2'' = L/s$, , vereinfacht sich die Faraday-Drehung $\phi 2$ zu:

$$\phi 2 = 2\ V\ z/s\ (I1 - I2).$$

Im Fehlerfall ist also mit dem ersten Stromsensor die Stromstärke des Fehlerstroms und mit dem zweiten Stromsensor eine mit der relativen Lage des Fehlerorts (z/L) gewichteten Fehlerstromstärke meßbar. Mittels zweier unabhängiger Messungen können 2 Meßgrößen direkt bestimmt werden.

Die Meßsignale beider Stromsensoren werden einem elektronischen System zugeführt und dort ausgewertet. Beide Faraday-Drehungen $\phi 1$ und $\phi 2$ werden ins Verhältnis gesetzt, wobei die Genauigkeit unabhängig von der Lage des Fehlerorts ist, solange ein auswertbares optisches Signal vorliegt. Also im Ergebnis:

$$\phi 2/\phi 1 = z/(s\ N1);$$

bzw. mit der Beziehung N2 = N2" = L/s und N1 = N1" = N1' :

$$\phi 2/\phi 1 = z\ N2/(L\ N1).$$

Das Verhältnis $\phi 2/\phi 1$ liefert den Fehlerort z, bzw. die relative Entfernung z/L des Fehlerstromorts vom Beginn der Kabelstrecke.

Die Größe des elektrischen Stroms in der Kabelstrecke selbst und auch Fehlerströme, die in der Kabelstrecke zum Kabelschirm fliessen, sollen beim ersten Stromsensor keinen Effekt liefern. Daher wird die Lichtwellenleiterverbindung beider Faraday-Teilspulen des ersten Stromsensors so vorgenommen, daß die Wirkung des Magnetfeldes sowohl des Stroms der Energieader als auch des Kabelschirms in der Kabelstrecke auf die Lichtwellenleiterverbindung ausgeschaltet ist.

Es bestehen hierzu zwei grundsätzliche Möglichkeiten, entweder wird die Lichtwellenleiterverbindung außerhalb des Magnetfeldes von Energieader und Kabelschirm geführt oder die Wirkung des Magnetfeldes wird kompensiert.

Es wird daher vorgeschlagen, daß der Lichtweg im Magnetfeld der Energieader geführt wird. Hierzu werden zwei (möglicherweise umeinander gewundenene) Lichtwellenleiter verwendet. Der erste Lichtwellenleiter wird für die Sensorfunktion in der Hinleitung benutzt und der zweite für den Rückweg auf der Kabelstrecke als Kompensator einzusetzen. Diese Doppelleitung kann sogar in einem gemeinsamen Röhrchen untergebracht sein, welches im Kabel auf der Kabelstrecke integriert ist. Die Magnetfeldkompensation kommt dadurch zustande, daß von den Verbindungslichtwellenleitern kein Strom eingeschlossen wird.

Die Windungszahlen der Teilspulen des zweiten Stromsensors müssen nicht notwendigerweise gleich denen des ersten Stromsensors sein. Bei gleichen Windungszahlen liegt ein einfacher Zusammenhang vor, da $\phi 2/\phi 1 = z/L$ ist. Bei ungleichen Windungszahlen läßt sich dies im Rahmen der Meßwertverarbeitung berücksichtigen, z.B. können die Verstärkungsfaktoren der Fotoverstärker entsprechend angepaßt werden.

Es gibt 2 Typen von Schirmstromleitungen. Die eine Form ist die der Rohrform, die durch geradlinige Ausbreitung des Schirmstroms gekennzeichnet ist. Besondere Aufmerksamkeit allerdings verlangt die Installation des verteilten Stromsensors, wenn die Schirmstromleitung als geschraubte Leitung im Kabel liegt. Die Anordnung des verteilten Sensors für diesen Fall muß berücksichtigen, daß das Magnetfeld des Schirmstroms in Längsrichtung des Lichtwellenleiters wirkt und damit der Schirmstrom die Messung verfälschen kann.

Die verteilte Faraday-Teilspule wird bei einer um die Energieaderachse geschraubt geführten Schirmstromleitung aus zwei Lichtwellenleiterteilspulen aufgebaut. Es wird eine Lichtwellenleiterteilspule unter den Schirm und im Gegenschlag zur Schirmstromleitung gelegt. An das Ende dieser Spule (also am Ende der Kabelstrecke) wird eine zweite Lichtwellenleiterteilspule angefügt, die im Schirm parallel zur Schirmstromleitung liegt und zum Anfang der Kabelstrecke zurückläuft. Das Ende dieser Spule wird mit einem Spiegel versehen.

Die beschriebene Ausführung ist unabhängig von der Reihenfolge der Anordnung der beiden Teilspulen und auch der Lage der zugehörigen konzentrierten Spule, so daß die Anordnung beider Teilspulen auch so sein kann, daß der Lichtweg zuerst eine Lichtwellenleiterteilspule im Schirm und dann die zweite Lichtwellenleiterteilspule unter dem Schirm durchläuft. Die Windungszahlen der beiden hintereinander geschalteten Teilspulen sind nicht notwendigerweise identisch. Ihre Summe muß allerdings gleich der Windungszahl der zugehörigen konzentrierten Faraday-Spule sein. Die zugehörige konzentrierte Spule kann auch zwischen beiden verteilten Teilspulen angebracht sein.

Temperatureffekte in mechanisch tordierten Lichtwellenleitern erzeugen Störeinflüsse auf die Lage der Polarisationsebene, die die Nutzeffekte überlagern können. Es wird daher vorgesehen, daß am Ende jeden Stromsensors ein Spiegel zur Reflexion der Signale zum Anfang des Sensors vorhanden ist. Mit dieser Maßnahme werden torsionsbedingte reziproke Effekte in den Lichtwellenleitern kompensiert. Insbesondere tritt mit dieser Maßnahme eine Vereinfachung der Strommeßanordnung ein, weil durch die Rückführung der optischen Signale an die Einkoppelstelle eine weitere Auskoppelstelle überflüssig wird. Die Strommeßanordnung wird einseitig betreibbar.

Die Strommeßanordnung ist nicht nur in Einleiterkabeln sondern auch in Mehrphasenleitungen oder Kabeln mit Mehrfachadern einsetzbar, wobei für jede Phase oder jede Energieader die Strommeßanordnung im Kabel integriert wird. Im einfachsten Fall wird in der Kabelstrecke ein Kabel eingesetzt, in dem eine verteilte Faraday-Teilspule und die Lichtwellenleiter-Verbindung zwischen den konzentrierten Teilspulen des ersten Sensors vollständig integriert sind. In einer Ausgestaltung der Erfindung kann vorgesehen sein, daß alle Faraday-Teilspulen in einem Abschnitt eines Kabels integriert sind.

Konzentrierte Faraday-Spulen sind kurz. Aus wirtschaftlichen Gründen werden sie nicht im Kabel integriert, obwohl dies technisch möglich ist. Konzentrierte Faraday-Spulen werden als auf das Kabel aufschiebbare Spule hergestellt und über die Meßstellen geschoben und dort fixiert (Anfang und Ende der Kabelstrecke).

Die optische Verbindung der Lichtwellenleiter zwischen den Faraday-Teilspulen untereinander und/oder zwischen den Faraday-Teilspulen und der Auswerteeinrichtung, also die Herausführung an externe Einrichtungen (z.B. Auswerteeinrichtung) wird bei einer Ausführungsform in Muffen und/oder Endverschlüssen integriert.

Die Übergangsorgane (Garnituren, Muffen, Endverschlüsse, Isolatoren) werden demgemäß so ausgestaltet, daß sie in einer Ausführungsform die endseitigen Teilspulen und Einrichtungen der Sensoren, wie Spiegel, Ein- und Auskoppeleinrichtungen für Licht aufnehmen. Beispielsweise kann die Kabelstrecke, auf der die Strommeßanordnung eingesetzt wird, an einem Verbraucher (z.B. Transformator) enden. In diesem Fall wird man den Ort des Übergangs so nah wie möglich am Transformator wählen, um möglichst räumlich lückenlos an die Überwachung der Kabelstrecke die Betriebsüberwachung des Verbrauchers anzuschließen.

Wie schon erwähnt, kann mindestens ein Lichtwellenleiter der Strommeßanordnung als Sensor für Betriebzustände des Kabels oder als Kommunikationslichtwellenleiter auf der Kabelstrecke ausgebildet sein. Als typische Sensoren sind Temperatursensoren für Energiestrecken von Bedeutung. Als Sensor für Betriebszustände ist insbesondere der als Stützfaser eingebrachte Lichtwellenleiter einsetzbar. Es ist für den Betreiber einer Energiestrecke von besonderem Interesse, Heißstellen (hot spots) aufspüren zu können. Die Überwachung der Betriebszustände in einer verfahrensmäßigen Ausgestaltung der Erfindung kann unabhängig vom Betrieb der Strommeßanordnung zeitlich intermittierend oder simultan durch Zeit- oder Wellenlängenmultiplexverfahren mit dem Strommeßvorgang stattfinden. Hierbei werden die Signale der Betriebszustandssensoren zu einer Auswerteeinrichtung geführt und ausgewertet. Zusätzlich oder unabhängig von der Messung von Strom- oder Betriebsgrößen können Kommunikationsdaten über die Lichtwellenleiter der Strommeßanordnung geschickt werden. Hierzu werden die der Kommunikation dienenden Lichtwellenleiter an beiden Enden der Kabelstrecke über Kabelmuffen oder Endverschlüssen aus der Sensoranordnung herausgeführt und an Kommunikationseinrichtungen angeschlossen.

Die Stromeßanordnung hat den besonderen Vorteil, daß sie in Distanz- und/oder Vergleichsschutzeinrichtungen eingesetzt werden kann. Hierbei wird die Meßanordnung innerhalb eines Leitungsschutz- und/oder Überwachungssystem als Komponente verwendet. Eine solche Konfiguration ist herkömmlichen Einrichtungen zum Distanz- oder Vergleichsschutz überlegen. In einer verfahrensmäßigen Anwendung wird vorgeschlagen, die Meßwerte beider Stromsensoren in eine Auswertestation (die z. B. Komponente einer Netzleitwarte sein kann) zu führen und dort Fehlerstromstärke und/oder relativen Fehlerstromort ermitteln zu lassen.

Weiterhin lassen sich die beiden Stromsensoren unabhängig voneinander einsetzen. In dieser vereinfachten Ausführung entfällt die Möglichkeit der Fehlerortung.

Unabhängig von der Betriebsweise (entweder Einzelsensor oder simultaner Betrieb beider Sensoren) wird auf die Kabelstrecke nur von einer Seite aus zugegriffen. Das gesamte Spektrum der Meß- und Auswertesignale stehen an diesem einen Ende zur Weiterverarbeitung einer Auswerteeinrichtung in einer Leitwarte zur Verfügung. Bekannte Differentialschutzanordnungen haben den Nachteil, daß bei ihnen an beiden Enden der Kabelstrecke Verbindungen zum Kabel vorhanden sein müssen. Bei der Strommeßanordnung entfällt die Notwendigkeit externer Meßsignal- und Auslösesignalübertragung zwischen beiden Enden der Kabelstrecke.

Eine symmetrische Ausgestaltung einer Strommeßanordnung kann man erreichen, wenn die Strommeßanordnung doppelt und spiegelbildlich in der als Meßstrecke ausgebildeten Kabelstrecke integriert wird. Damit stehen an beiden Enden der Überwachungsstrecke Meß- und Betriebsdaten zur Verfügung. Weiterhin können über die Lichtwellenleiter der Strommeßanordnung digitale Kommunikationsaufgaben zwischen den Endstationen abgewickelt werden.

Der Schutzbereich beträgt 100 % der Kabelstrecke. Dies wird durch herkömmlichen Distanzschutz nicht erreicht. Bei der Verwendung der Strommeßanordnung kann absolute Selektivität erzielt werden (d.h. die fehlerhafte Strecke kann gezielt abgeschaltet werden). Diese Eigenschaft ist besonders dann von Vorteil, wenn bestehende Energieversorgungsnetze um zusätzliche Kabelstrecken erweitert werden. Die Möglichkeit der Fehlerortung erlaubt eine eindeutige Zuordnung des Fehlers zum bestehenden Netz oder zum Kabel, so daß bereits im Betrieb befindliche Schutzreinrichtungen in ihrer Funktion nicht beeinträchtigt werden.

Besonders günstig ist die Situation bei einseitig gespeisten Energiestrecken. Dort entspricht die Größe des Fehlerstroms dem eingespeisten Strom. Hieraus ergeben sich technische Vorteile beim Einsatz der Strommeßanordnung in einseitig gespeisten Energiestrecken. In diesem Fall wird die Meßanordnung zu einem Dreifachsystem. Mit ihr ist die Messung (und Überwachung) des Betriebsstroms möglich und sie ist als Komponente eines Fehlerstrom-, als auch eines Distanzschutzsystems verwendbar.

Ausführungsbeispiele der Erfindung werden in den Figuren näher beschrieben. Sie zeigen im Einzelnen:

**Fig.** 1    schematisch die Strommeßanordnung,

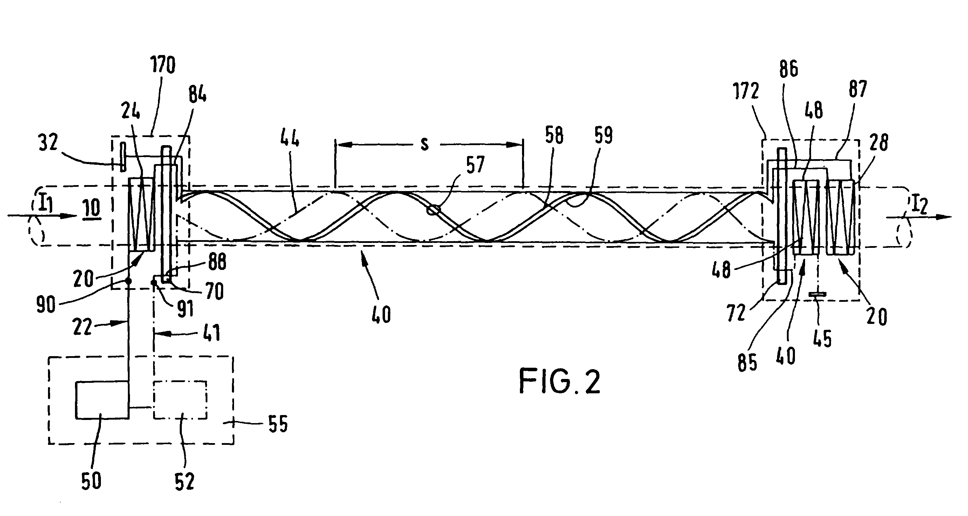

**Fig.** 2    eine erste Ausführungsform der Strommeßanordnung im Detail,

**Fig.** 3    eine Ausführungsform des zweiten Stromsensors,

**Fig.** 4    eine Ausführungsform des verteilten Stromsensors.

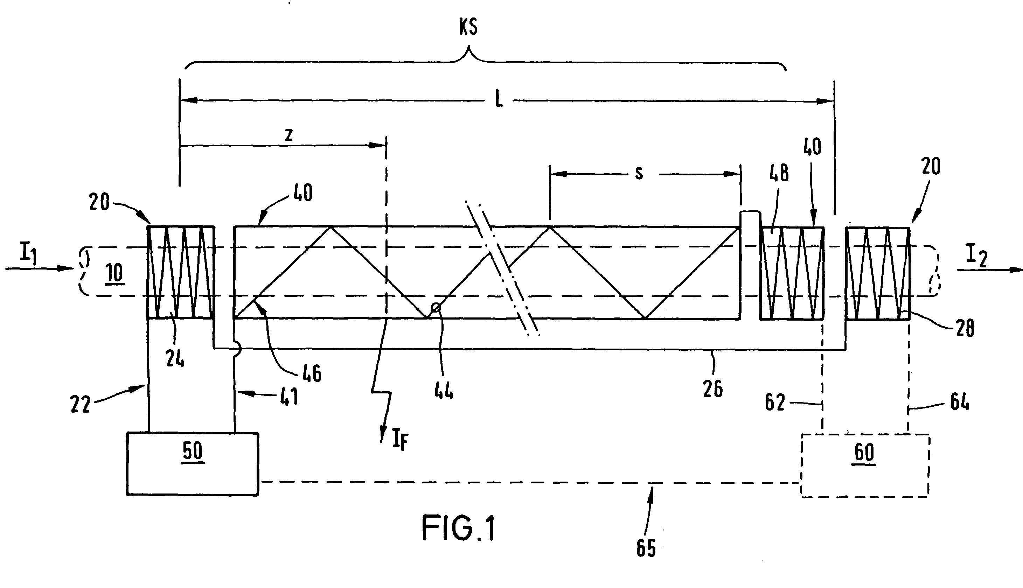

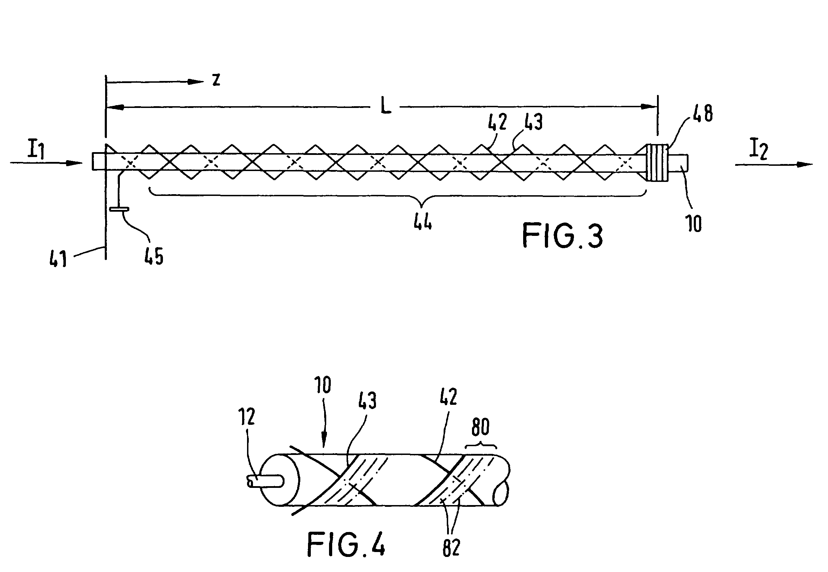

In **Fig.** 1 ist schematisch die Strommeßanordnung auf einer Kabelstrecke **KS** eines Kabels **10** dargestellt. Der erste Stromsensor **20** besteht aus zwei hintereinander geschalteten, eng gewickelten Lichtwellenleiterspulen oder Faraday-Teilspulen **24**, **28** mit gleicher Windungszahl **N1',N1''** und entgegengesetzter Wicklungsrichtung an jedem Ende der Kabelstrecke **KS**. Zwischen den Lichtwellenleiterspulen **24,28** besteht eine Lichtwellenleiter-Verbindung **26**. Sie ist so in der Kabelstrecke **KS** angebracht, daß das Magnetfeld der Energieader (**12** in **Fig.** 4) und des Schirms (**80** in **Fig.** 4) keinen Einfluß auf die Verbindung **26** ausübt.

Der zweite Stromsensor **40** besteht aus einer über der Kabelstrecke **KS** verteilten Lichtwellenleiterspule oder Faraday-Teilspule **44** mit der Windungszahl **N2'** und einer am Ende der Kabelstrecke konzentrierten weiteren Lichtwellenleiterspule oder Faraday-Teilspule **48** mit der Windungszahl **N2''**, die hintereinander geschaltet sind. Die Wicklung der einen Faraday-Teilspule **44** ist der Wickelrichtung der zweiten Faraday-Teilspule **48** entgegengesetzt. Die Anzahl der Windungen **N2'**, **N2''** der Teilspulen **44,48** sind einander gleich.

Beide Stromsensoren **20,40** werden gemeinsam in einer Kabelstrecke **KS** installiert.

Die Länge der Kabelstrecke **KS** ist mit **L**, die Ortskoordinate auf der Kabelstrecke **KS** wird mit **z** bezeichnet. Am Ort **z** ist ein Erdschluß mit einem Fehlerstrom **I$_F$** angedeutet. Die Schlaglänge der verteilten Lichtwellenleiterspule **44** des zweiten Stromsensors ist **s**. Die in der Energieader **12** am Anfang und am Ende der Kabelstrecke fließenden Ströme werden mit **I1,I2** bezeichnet.

Von außerhalb des Kabels werden beide Stromsensoren **20,40** über die Lichtwellenleiter **22,41** von einer Steuerstation **50**, die Komponente einer Leitwarte **55** sein kann, angesteuert. Vom Ende beider Stromsensoren **20,40** bestehen Verbindungen über Lichtwellenleiter **62,64** zu einer Vorrichtung **60**. Zwischen der Vorrichtung **60** und der Steuerstation **50** besteht eine Nachrichtenleitung **65**, möglicherweise in Form eines ebenfalls im Kabel integrierten Lichtwellenleiters. Die Vorrichtung **60** und die Nachrichtenleitung **65** sind gestrichelt gezeichnet, womit angedeutet werden soll, daß die Strommeßanordnung in einer vorteilhaften Ausgestaltung auch für die Datenübertragung zwischen Anfang und Ende der Kabelstrecke **KS** ausgestattet sein kann. Die Datenübertragung läuft hierbei über die Lichtwellenleiter der Strommeßanordnung, ohne Hinzufügung weiterer Lichtwellenleiter. Die Vorrichtung **60** umfaßt mindestens eine Spiegelanordnung für jeden Lichtwellenleiter **62,64** zur Reflexion des Lichts zum Anfang der Stromsensoren **20,40**. Vorteilhafterweise sind die Spiegel im Kabel integriert. In der Steuerstation **50** werden die Strommeßwerte und physikalische Daten über Betriebszustände der Kabelstrecke ermittelt und ausgewertet und der Kommunikationsverkehr abgewickelt.

In **Fig**. 2 sind beide Stromsensoren **20,40** auf einer Strecke eines Energiekabels **10** ausführlicher dargestellt. Außerhalb des Kabels **10** liegt eine Leitwarte **55**, von der aus jeweils Lichtwellenleiter **22,41** zu den beiden Stromsensoren **20,40** laufen. Ein die Polarisationsebene stabil führender Lichtwellenleiter **22** des ersten Stromsensors **20** ist jeweils am Beginn und am Ende der Kabelstrecke **KS** als konzentrierte Spule (**24,28**) gewickelt. Beide Windungszahlen **N1',N1''** der Spulen **24,28** sind gleich. Zwischen den Faraday-Spulen **24,28** besteht eine Lichtwellenleiterverbindung **57**, die als Doppelleitung **58,59** geführt ist. Die Lichtwellenleiter der Doppelleitung **57** können gemeinsam in einem Röhrchen untergebracht und im Kabel integriert sein. Der eine Lichtwellenleiter **58** stellt die Verbindung zwischen Spule **24** und Spule **28** dar. Der zweite Lichtwellenleiter **59** läuft vom Ende der zweiten Faraday-Spule **28** in der Doppelleitung **57** zum Anfang der Kabelstrecke zurück. Die Drehung der Polarisationsebene in der Hinleitung **58** wird auf dem Rückweg über den Lichtwellenleiter **59** zurückgedreht, so daß die Wirkung des Magnetfelds auf der Länge der Kabelstrecke kompensiert ist. Das Ende des Lichtwellenleiters **59** ist mit einem Spiegel **32** versehen. Über ihn wird das optische Signal aus dem Stromsensor **20** zurück zur Steuerstation **50** reflektiert.

Der Lichtwellenleiter **41** des zweiten Sensors **40** ist mit langem Schlag bei einer Schlaglänge **s** auf der Kabelstrecke **KS** als verteilte Faraday-Spule **44** geführt. Am Ende der Kabelstrecke **KS** ist der Lichtwellenleiter **42** mit der konzentrierten Faraday-Teilspule **48** verbunden. Die Windungszahlen N2',N2'' der Spulen **44,48** sind gleich. Der optische Weg des zweiten Stromsensors **40** ist ebenfalls mit einem Spiegel **45** abgeschlossen. Für die Anordnung in **Fig**. 2 wird dabei ein Schirm in Rohrform vorausgesetzt.

Beide Stromsensoren **20,40** werden vom Anfang der Kabelstrecke aus über Lichtwellenleiter **22,41** von den Steuerstationen **50,52** (z.B. Komponenten einer Leitwarte **55**) angesprochen. Von den Steuerstationen **50,52** gehen die optischen Signale in die Stromsensoren und die Meßgrößen laufen dorthin zurück. Die dargestellte Strommeßanordnung hat wegen des nur an einer Stelle vorhandenen Zugangs auf die Kabelstrecke eine sehr einfache topologische Struktur.

Der Übergang zwischen dem Kabel **10** am Anfang und am Ende der Kabelstrecke **KS** wird jeweils mit einer Kabelmuffe **70,72** hergestellt. Durch die Kabelmuffen **70,72** sind die jeweiligen Lichtwellenleiter **22,41,57,46** an den Verbindungsstellen **84,85,86, 87,88,90,91** hindurchgeführt. In der Muffe **70** kann auch der Spiegel **32** integriert sein, so daß dort der Lichtwellenleiter nicht durchgeführt wird, sondern mit dem Spiegel **32** in der Muffe **70** endet.

Gestrichelt sind in der **Fig**. 2 zwei Installationsmuffen **170,172** dargestellt, die anstelle der Muffen **70,72** vorgesehen werden können. Die Installationsmuffen **170,172** umfassen neben der Durchführung der Energieader **12** und der Schirmleitung **80** auch die konzentrierten Faraday-Teilspulen **24**, bzw. **28** und **48**, die Spiegel **32,45** und die Lichtwellenleiterverbindungen **90,91** zur Leitwarte **55**. Die Installationsmuffen **170,172** sind komplette Baueinheiten, in denen die erwähnten Teile der Strommeßanordnung integriert sind.

Die **Fig**. 3 zeigt schematisch und die **Fig**. 4 zeigt im Detail die Anordnung der verteilten Faraday-Spule **44** des zweiten Stromsensors **40** eines Kabels **10**, dessen Schirmdrahtleitung **80** geschraubt geführt ist. Wie schon in **Fig**. 2 dargestellt, befindet sich am Ende der verteilten Faraday-Spule **44** ein Spiegel **45**.

Wegen des störenden Magnetfeldes des Schirmstroms wird eine auf Kompensation abgestimmte Anordnung des verteilten Stromsensors **44** gewählt. Die in der Kabelstrecke mit relativ langem Schlag liegende Faraday-Spule **44** wird aus zwei Lichtwellenleiter-Leitungen **42,43** gebildet. Ein Lichtwellenleiter oder Teilspule **42** wird unter den Kabelschirm **80** im Gegenschlag zu ihm gelegt. Der andere Lichtwellenleiter oder Teilspule **43** läuft im Kabelschirm **80** parallel zu den (strichpunktiert gezeichneten) Schirmdrähten **82**. Die Summe der Windungen beider Lichtwellenleiter **42,43** ist gleich gleich der Windungszahl **N2''** des konzentrierten Stromsensors **48**. Auf den unter dem Schirm **80** liegenden Lichtwellenleiter **42** wirkt das Magnetfeld der Energieader **12** und das Magnetfeld des Schirmstroms. Die Wirkung des Magnetfeldes der Schirmstromleitung **80** wird durch diese Anordnung kompensiert. Die Reihenfolge der Anordnung beider Lichtwellenleiter **42,43** ist beliebig. D.h. für die Kompensationswirkung ist es unerheblich, ob das Licht zuerst im Lichtwellenleiter **42** unter dem Schirm zur konzentrierten Spule **48** und anschließend im Lichtwellenleiter **43** in der Schirmlage bis zum Spiegel **45** läuft oder ob es zuerst im Lichtwellenleiter **43** in der Schirmlage zur konzentrierten Spule **48** und dann unter dem Schirm zum Spiegel **45** läuft.

**Patentansprüche**

1. Strommeßanordnung für eine Strecke (KS) einer Energieader (12) eines Energiekabels (10) mit teilweise im Energiekabel (10) integrierten, polarisationserhaltenden Lichtwellenleitern (22,42), die als Faraday-Teilspulen (24,28) ausgebildet und hintereinander geschaltet sind und mit an einem Ende der Strecke (KS) vorhandenen Einrichtungen zum Ein- und Auskoppeln von Licht im die bzw. aus dem Lichtwellenleitern und mit einer Einrichtung (50) zum Auswerten ausgekoppelten optischer Signale, **dadurch gekennzeichnet,** daß, mindestens einer Energieader **(12)** im Energiekabel **(10)** zugeordnet,

   - ein erster Stromsensor **(20)** aus einer am Anfang und einer am Ende der Strecke **(KS)** konzentrierten Faraday-Teilspule **(24,28)** gebildet ist und daß die Lichtwellenleiterverbindung **(26)** zwischen den Teilspulen **(24,28)** unbeeinflußt vom Magnetfeld der Energieader **(12)** angeordnet ist
   - und ein zweiter Stromsensor **(40)** aus einer über die Strecke **(KS)** verteilten Faraday-Teilspule **(44)** und aus einer weiteren an einem Ende der Strecke **(KS)** konzentrierten Faraday-Teilspule **(48)** gebildet ist,
   - daß die Faraday-Teilspulen **(24,28,44,48)** jedes Stromsensors **(20,40)** untereinander nahezu identische Wicklungszahl und gegenläufige Wicklungsrichtung haben
   - und daß am Ende jeden Stromsensors **(20,40)** ein Spiegel **(32,45)** zur Reflexion der Signale vorhanden ist.

2. Strommeßanordnung nach Anspruch 1, **dadurch gekennzeichnet**, daß bei einer um die Energieaderachse geschraubt geführten Schirmleitung **(80)** die verteilte Faraday-Teilspule **(44)**, unabhängig von der Reihenfolge der Anordnung und unabhängig von der Lage der weiteren konzentrierten Faraday-Teilspule **(48)**, aus einer unter der Schirmleitung **(80)** und im Gegenschlag zur Schirmleitung **(80)** liegenden Teilspule **(42)** und vom Ende der Strecke **(KS)** mit einer im Schirm parallel zur Schirmleitung **(80)** liegenden, zum Anfang der Strecke **(KS)** zurückgeführten anderen Teilspule **(43)** gebildet ist, die dort mit dem Spiegel **(32)** versehen ist.

3. Strommeßanordnung nach einem der vorhergehenden Ansprüche, **dadurch gekennzeichnet**, daß als Lichtwellenleiter **(22,41)** ein mechanisch tordierter Lichtwellenleiter eingesetzt ist.

4. Strommeßanordnung nach Anspruch 3, **dadurch gekennzeichnet**, daß mindestens ein Lichtwellenleiter **(22,41)** um eine Stützfaser schraubenförmig gewunden ist.

5. Strommeßanordnung nach Anspruch 4, **dadurch gekennzeichnet**, daß die Stützfaser als polarisationserhaltender Lichtwellenleiter ausgebildet ist.

6. Strommeßanordnung nach einem der Ansprüche 1 oder 2 , **dadurch gekennzeichnet**, daß als Lichtwellenleiter **(22,41)** Fasern vom Typ spun high birefringence eingesetzt sind.

7. Strommeßanordnung nach einem der vorhergehenden Ansprüche, **dadurch gekennzeichnet**, daß die Stützfaser und/oder ein Lichtwellenleiter **(22,41)** als Sensor für Betriebsgrößen und/oder als Kommunikationslichtwellenleiter ausgebildet ist.

8. Strommeßanordnung nach einem der vorhergehenden Ansprüche, **dadurch gekennzeichnet**, daß die Verbindung zwischen den Faraday-Teilspulen **(24,28)** des ersten Stromsensors **(20)** durch eine parallel liegende Lichtwellenleiter-Doppelleitung **(57)** im Magnetfeld der Energieader **(12)** realisiert ist.

9. Strommeßanordnung nach einem der Ansprüche 1 bis 7, **dadurch gekennzeichnet**, daß die Lichtwellenleiterverbindung der Faraday-Teilspulen **(24,28)** des ersten Stromsensors **(20)** außerhalb des Magnetfeldes von Energieader **(12)** und Schirmleitung **(80)** liegt.

10. Strommeßanordnung nach einem der vorhergehenden Ansprüche, **dadurch gekennzeichnet**, daß alle Faraday-Teilspulen **(24,28,44, 48)** einer Phase oder einer Energieader (**12**) in einem Abschnitt (**KS**) des Energiekabels (**10**) integriert sind.

11. Strommeßanordnung nach einem der vorhergehenden Ansprüche, **dadurch gekennzeichnet**, daß Verbindungsstellen (**84,85,86,87, 88,90,91**) der Lichtwellenleiter (**22,41**) zwischen den Faraday-Teilspulen (**24,28,44,48**) untereinander und/oder zwischen den Faraday-Teilspulen (**24,44**) und der Leitwarte (**55**) in Installationsmuffen (**170,172**) und/oder Endverschlüssen integriert sind.

12. Strommeßanordnung nach einem der vorhergehenden Ansprüche, **dadurch gekennzeichnet**, daß die konzentrierten Faraday-Teilspulen (**24,28,48**) in Installationsmuffen (**170,172**) und/oder Endverschlüssen integriert sind.

13. Strommeßanordnung nach einem der vorhergehenden Ansprüche, **dadurch gekennzeichnet**, daß die Windungszahlen (**N1',N1'',N2', N2''**) aller Faraday-Teilspulen (**24,28,44,48**) untereinander gleich sind.

14. Strommeßanordnung nach einem der vorhergehenden Ansprüche, **dadurch gekennzeichnet**, daß in einer Energiestrecke (**KS**) eine zweite Strommeßanordnung (**20,40,55**) mit räumlicher Vertauschung von Anfang und Ende angeordnet ist.

15. Strommeßanordnung nach einem der vorhergehenden Ansprüche, **dadurch gekennzeichnet**, daß die Strommeßanordnung (**20,40,55**) als Komponente in einem Leitungsschutz- und/oder Überwachungssystem verwendet ist.

16. Strommeßanordnung nach einem der vorhergehenden Ansprüche, **dadurch gekennzeichnet**, daß die Faraday-Meßwerte der Stromsensoren (**20,40**) in eine Leitwarte (**55**) zur Ermittlung der Fehlerstromstärke (**I$_F$**) und/oder des relativen Fehlerstromortes (**z/L**) geführt sind.

17. Strommeßanordnung nach Anspruch 7, **dadurch gekennzeichnet**, daß Signale des Betriebsgrößensensors zu einer Leitwarte (**55**) geführt und ausgewertet und/oder zwischen jeweils an den Enden der Kabelstrecke (**KS**) angeschlossenenen Kommunikationsstationen Kommunikationsdaten über die Strommeßanordnung (**20,40,55**) geschickt sind.

18. Strommeßanordnung nach einem der Ansprüche 7 bis 17, **dadurch gekennzeichnet**, daß das Strommessen und das Betriebsgrößenüberwachen und/oder das Datenübertragen im Multiplexbetrieb vorgenommen ist.

**Claims**

1. A current-measuring arrangement for a section (**KS**) of a power core (**12**) of a power cable (**10**), having polarisation-maintaining optical waveguides (**22,48**) which are partially integrated in the power cable (**10**), are designed as Faraday coil sections (**24,28**) and are connected in series, and having devices which are present at one end of the section (**KS**) and are intended for injecting and extracting light into and from the optical waveguides, and having a facility (**50**) for evaluating extracted optical signals,
**characterised** in that, assigned to at least one power core (**12**) in the power cable (**10**),

- a first current sensor (**20**) is formed from Faraday coil sections (**24,28**) concentrated one at the beginning and one at the end of the section (**KS**) and in that the optical-waveguide connection (**26**) between the coil sections (**24,28**) is arranged so as to be uninfluenced by the magnetic field of the power core (**12**)
- and a second current sensor (**40**) is formed from a Faraday coil section (**44**) distributed over the section (**KS**) and from a further Faraday coil section (**48**) concentrated at one end of the section (**KS**),
- in that the Faraday coil sections (**24,28,44,48**) of each current sensor (**20,40**) have, amongst each other, a virtually identical number of windings [sic] and opposite winding directions
- and in that a mirror (**32,45**) for reflecting the signals is present at the end of each current sensor (**20,40**).

2. A current-measuring arrangement according to Claim 1, **characterised** in that, in the case of a shielding line (**80**) run helically around the axis of the power core, the distributed Faraday coil section (**44**), irrespective of the order of the arrangement and irrespective of the position of the further concentrated Faraday coil section (**48**), is formed from a coil section (**42**) lying under the shielding line (**80**) and with a cross lay relative to the shielding line (**80**) and, from the end of the section (**KS**), with another coil section (**43**) which lies in the shield parallel to the shielding line (**80**), is led back to the beginning of the section (**KS**) and is fitted there with the mirror (**32**).

3. A current-measuring arrangement according to one of the preceding claims, **characterised** in that a mechanically twisted optical waveguide is employed as the optical waveguides (**22,41**).

4. A current-measuring arrangement according to Claim 3, **characterised** in that at least one optical waveguide **(22,41)** is wound helically around a supporting fibre.

5. A current-measuring arrangement according to Claim 4, **characterised** in that the supporting fibre is designed as a polarisation-maintaining optical waveguide.

6. A current-measuring arrangement according to one of Claims 1 or 2, **characterised** in that fibres of the spun high birefringence type are employed as the optical waveguides **(22,41)**.

7. A current-measuring arrangement according to one of the preceding claims, **characterised** in that the supporting fibre and/or one optical waveguide **(22,41)** is designed as a sensor for operating quantities and/or as a communication optical waveguide.

8. A current-measuring arrangement according to one of the preceding claims, **characterised** in that the connection between the Faraday coil sections **(24,28)** of the first current sensor **(20)** is effected by a parallel optical-waveguide double line **(57)** in the magnetic field of the power core **(12)**.

9. A current-measuring arrangement according to one of Claims 1 to 7, **characterised** in that the optical-waveguide connection of the Faraday coil sections **(24,28)** of the first current sensor **(20)** lies outside the magnetic field of power core **(12)** and shielding line **(80)**.

10. A current-measuring arrangement according to one of the preceding claims, **characterised** in that all the Faraday coil sections **(24,28,44,48)** of one phase or of one power core **(12)** are integrated in a portion **(KS)** of the power cable **(10)**.

11. A current-measuring arrangement according to one of the preceding claims, **characterised** in that connecting points **(84,85,86,87,88,90,91)** of the optical waveguides **(22,41)** between the Faraday coil sections **(24,28,44,48)** amongst each other and/or between the Faraday coil sections **(24,44)** and the control centre **(55)** are integrated in installation coupling boxes **(170,172)** and/or sealing ends.

12. A current-measuring arrangement according to one of the preceding claims, **characterised** in that the concentrated Faraday coil sections **(24,28,48)** are integrated in installation coupling boxes **(170,172)** and/or sealing ends.

13. A current-measuring arrangement according to one of the preceding claims, **characterised** in that the numbers of turns **(N1',N1",N2',N2")** of all the Faraday coil sections **(24,28,44,48)** amongst each other are equal.

14. A current-measuring arrangement according to one of the preceding claims, **characterised** in that a second current-measuring arrangement **(20,40,55)** with beginning and end spatially changed round is arranged in a power section **(KS)**.

15. A current-measuring arrangement according to one of the preceding claims, **characterised** in that the current-measuring arrangement **(20,40,55)** is used as a component in a line-protection and/or monitoring system.

16. A current-measuring arrangement according to one of the preceding claims, characterised in that the Faraday measured values of the current sensors **(20,40)** are passed to a control centre **(55)** for the determination of the intensity ($I_F$) of the fault current and/or of the relative location (z/L) of the fault current.

17. A current-measuring arrangement according to Claim 7, **characterised** in that signals of the operating-quantity sensor are passed to a control centre **(55)** and evaluated and/or communication data are sent via the current-measuring arrangement **(20,40,55)** between communication stations connected to each of the ends of the cable section **(KS)**.

18. A current-measuring arrangement according to one of Claims 7 to 17, **characterised** in that the current measurement and the monitoring of the operating quantities and/or the data transmission are carried out in multiplex operation.

**Revendications**

1. Dispositif de mesure du courant pour un tronçon (KS) d'un conducteur d'énergie (12) appartenant à un câble de transport d'énergie (10), comprenant des guides d'ondes lumineuses (22, 41) conservant la polarisation, partiellement intégrés dans le câble de transport d'énergie (10), qui forment des bobines de Faraday partielles (24, 28) et sont connectés l'un à la suite de l'autre, ainsi que des dispositifs prévus à une extrémité du tronçon (KS) et servant à injecter de la lumière dans les guides d'ondes lumineuses ou à l'en extraire, et qu'un dispositif (50) pour l'analyse des signaux optiques extraits,
caractérisé en ce qu'à au moins un conducteur de transport d'énergie (12) du câble de transport d'énergie (10), sont associés,

- un premier capteur de courant (20) formé d'une bobine de Faraday partielle concentrée (24, 28) agencée au début et à la fin du tronçon (KS), la liaison par guides d'ondes lumineuses (26) entre les bobines partielles (24, 28) n'étant pas influencée par le champ magnétique du conducteur de transport d'énergie (12),

-  et un deuxième capteur de courant (40) formé d'une bobine de Faraday partielle (44) répartie sur le tronçon (KS) et d'une autre bobine de Faraday partielle concentrée (48) prévue à une extrémité du tronçon (KS),

-  en ce que les bobines de Faraday partielles (24, 28, 44, 48) de chaque capteur de courant (20, 40) ont des nombres de spires presque identiques entre eux et des sens d'enroulement opposés,

-  et en ce qu'à l'extrémité de chaque capteur de courant (20, 40) est prévu un miroir (32, 45) pour la réflexion des signaux.

2.  Dispositif de mesure du courant selon la revendication 1, caractérisé en ce que, dans le cas d'un conducteur de blindage (80) disposé en hélice autour de l'axe du conducteur de transport d'énergie, la bobine de Faraday partielle répartie (44) est formée, indépendamment de l'ordre de succession de l'agencement et indépendamment de la position de l'autre bobine de Faraday partielle concentrée (48), d'une bobine partielle (42) placée sous le conducteur de blindage (80) et enroulée en sens inverse du conducteur de blindage (80) et d'une autre bobine partielle (43) revenant de la fin du tronçon (KS) au début du tronçon (KS) et placée dans le blindage parallèlement au conducteur de blindage (80), cette autre bobine étant munie du miroir (32) à cet endroit.

3.  Dispositif de mesure du courant selon l'une des revendications précédentes, caractérisé en ce qu'on utilise comme guide d'ondes lumineuses (22, 41), un guide d'ondes lumineuses torsadé mécaniquement.

4.  Dispositif de mesure du courant selon la revendication 3, caractérisé en ce qu'au moins un guide d'ondes lumineuses (22, 41) est enroulé en hélice autour d'une fibre de support.

5.  Dispositif de mesure du courant selon la revendication 4, caractérisé en ce que la fibre de support constitue un guide d'ondes lumineuses conservant la polarisation.

6.  Dispositif de mesure du courant selon une des revendications 1 et 2, caractérisé en ce qu'on utilise comme guides d'ondes lumineuses (22, 41) des fibres du type "spun high birefringence".

7.  Dispositif de mesure du courant selon l'une des revendications précédentes, caractérisé en ce que la fibre de support et/ou le guide d'ondes lumineuses (22, 41) forment un capteur pour détecter des grandeurs de fonctionnement et/ou un guide d'ondes lumineuses de communication.

8.  Dispositif de mesure du courant selon l'une des revendications précédentes, caractérisé en ce que la liaison entre les bobines de Faraday partielles (24, 28) du premier capteur de courant (20) est réalisée par une ligne double de guides d'ondes lumineuses (57) disposées en parallèle dans le champ magnétique du conducteur de transport d'énergie (12).

9.  Dispositif de mesure du courant selon l'une des revendications 1 à 7, caractérisé en ce que la liaison par guides d'ondes lumineuses entre les bobines de Faraday partielles (24, 28) du premier capteur de courant (20) est située en dehors du champ magnétique du conducteur de transport d'énergie (12) et du conducteur de blindage (80).

10. Dispositif de mesure du courant selon l'une des revendications précédentes, caractérisé en ce que toutes les bobines de Faraday partielles (24, 28, 44, 48) d'une phase ou d'un conducteur de transport d'énergie (12) sont intégrées dans un segment (KS) du câble de transport d'énergie (10).

11. Dispositif de mesure du courant selon l'une des revendications précédentes, caractérisé en ce que les zones de liaison (84, 85, 86, 87, 88, 90, 91) par guides d'ondes lumineuses (22, 41) entre deux bobines de Faraday partielles (24, 28, 44, 48) et/ou entre les bobines de Faraday partielles (24, 44) et le dispositif de surveillance de conduction (55) sont intégrées dans des manchons d'installation (170, 172) et/ou dans des boîtes d'extrémité.

12. Dispositif de mesure du courant selon l'une des revendications précédentes, caractérisé en ce que les bobines de Faraday partielles concentrées (24, 28, 48) sont intégrées dans des manchons d'installation (170, 172) et/ou dans des boîtes d'extrémité.

13. Dispositif de mesure du courant selon l'une des revendications précédentes, caractérisé en ce que les nombres de spires (N1', N1", N2', N2") de toutes les bobines de Faraday partielles (24, 28, 44, 48) sont identiques entre eux.

14. Dispositif de mesure du courant selon l'une des revendications précédentes, caractérisé en ce que, dans un tronçon de transport d'énergie (KS), est disposé un deuxième dispositif de mesure du courant (20, 40, 55) avec permutation dans l'espace entre le début et la fin.

15. Dispositif de mesure du courant selon l'une des revendications précédentes, caractérisé en ce que le dispositif de mesure du courant (20, 40, 55) est utilisé comme élément constitutif dans un système de protection de ligne et/ou de surveillance.

16. Dispositif de mesure du courant selon l'une des revendications précédentes, caractérisé en ce que les valeurs de mesure de Faraday des capteurs de courant (20, 40) sont transmises à un dispositif de surveillance de la conduction (55) pour déterminer l'intensité du courant de défaut ($I_F$) et/ou l'emplacement relatif du courant de défaut (z/L).

17. Dispositif de mesure du courant selon la revendication 7, caractérisé en ce que les signaux du capteur de grandeurs de fonctionnement sont transmis à un dispositif de surveillance de la conduction (55) et analysés et/ou des données de communication sont transmises à travers le dispositif de mesure du courant (20, 40, 55) entre des postes de communication raccordés aux extrémités du tronçon de câble (KS).

18. Dispositif de mesure du courant selon l'une des revendications 7 à 17, caractérisé en ce que la mesure du courant et la surveillance des paramètres de fonctionnement et/ou la transmission des données s'effectuent en mode multiplex.

FIG.1

EP 0 584 448 B1

FIG.2

FIG.3

FIG.4

EP 0 584 448 B1